# EUROPEAN PATENT SPECIFICATION

(11) **EP 3 370 398 B1**
(45) Date of publication and mention of the grant of the patent: **13.11.2019**
(21) Application number: 18154869.4
(22) Date of filing: 02.02.2018
(51) Int. Cl.: H04M 1/02, H04M 1/18

(54) **SHELL ASSEMBLY, ELECTRONIC DEVICE AND MOBILE PHONE HAVING SAME**
HÜLLENANORDNUNG, ELEKTRONISCHE VORRICHTUNG UND MOBILTELEFONE DAMIT
ENSEMBLE DE COQUE, DISPOSITIF ÉLECTRONIQUE ET TÉLÉPHONE MOBILE LE COMPORTANT

(30) Priority: 01.03.2017 CN 201710117758; 01.03.2017 CN 201720195841 U
(43) Date of publication of application: 05.09.2018
(73) Proprietor: Guangdong Oppo Mobile Telecommunications Corp., Ltd, Dongguan, Guangdong 523860 (CN)
(72) Inventor: ZHANG, Wenzhen, Chang'an Dongguan, Guangdong (CN); ZHANG, Hui, Chang'an Dongguan, Guangdong (CN)
(74) Representative: Mewburn Ellis LLP

(56) References cited:
- US-A1- 2009 268 424
- US-A1- 2014 232 607

## Description

### TECHNICAL FIELD

This disclosure relates to the technical field of electronic devices, and more particularly to a shell assembly, an electronic device and a mobile phone having the same.

### BACKGROUND

With the advancement of science and technology, electronic devices (such as smart phones) are being more and more light and thin. When a thickness of the electronic devices being less than a certain value, an overall strength of the electronic devices will be reduced, then the electronic devices can easily be bent, and the battery will easily be damaged, which will seriously lead to a fire.

US 2014/0232607 discloses a mobile terminal including a terminal body having a battery and an antenna module; a printed circuit board having one or more processors disposed between the battery and the antenna module, and mounted to the terminal body; a partition wall formed at the terminal body such that a region for mounting the antenna module is partitioned from a region for mounting the printed circuit board; and a shielding member coupled to the partition wall, such that electromagnetic interference of an antenna device due to an operation of the processor is prevented

### SUMMARY

According to the present invention, there is provided a shell assembly of an electronic device as set out in claim 1. The shell assembly includes a shell and at least one reinforcing pillar. The shell includes a plate and a side plate extending from the plate. The plate and the side plate cooperatively defines a receiving cavity at least configured for receiving a battery. The at least one reinforcing pillar is received in the receiving cavity and adjacent to the side plate. When the battery is received in the receiving cavity, the at least one reinforcing pillar is positioned between the battery and the side plate.

An electronic device includes a shell, at least one reinforcing pillar, and a battery. The shell includes a plate and a side plate extending from the plate. The plate and the side plate cooperatively defines a receiving cavity. The at least one reinforcing pillar is received in the receiving cavity. The battery is received in the receiving cavity, the at least one reinforcing pillar is arranged adjacent to the side plate and is positioned between the battery and the side plate.

A mobile phone, includes a shell, at least one reinforcing pillar, a display unit and a battery. The shell includes a plate and a side plate extending from the plate. The plate and the side plate cooperatively defines a receiving cavity. The at least one reinforcing pillar is received in the receiving cavity. The display unit is mounted on a front surface of the shell assembly, and is at least partially imbedded in the shell assembly. The battery is received in the receiving cavity, the at least one reinforcing pillar is arranged adjacent to the side plate and is positioned between the battery and the side plate.

### BRIEF DESCRIPTION OF THE ACCOMPANYING DRAWINGS

The above and/or additional aspects and advantages of the disclosure will be clear and easy to understand, based on the description of the embodiments combined with the following drawings.
FIG. 1 is a schematic top view of a shell assembly of an electronic device according to a first embodiment of the disclosure.
FIG. 2 is a schematic side view of the shell assembly of the electronic device according to the first embodiment of the disclosure.
FIG. 3 is a partial enlarged schematic view on a location of A in FIG.2.
FIG. 4 is a schematic structure diagram of an electronic device according to a second embodiment of the disclosure.
FIG. 5 is a block diagram of the electronic device according to the second embodiment of the disclosure.

### DETAILED DESCRIPTION OF ILLUSTRATED EMBODIMENTS

The present disclosure will now be described in detail and completely with reference to the accompanying drawings of the embodiments, in which, same or similar reference numbers indicate same or similar elements, or indicate elements with a same or similar function. The following embodiments according to the drawings are illustrative, and are only used to explain the disclosure, and cannot be interpreted as limitations of the disclosure.

In descriptions of the disclosure, It will be appreciated that terms "length", "width", "up", "down", "front", "back", "left", "right", "vertical", "level", "top", "bottom", "inside", and "outside" and so on, indicates a location or position relationship based on the location or position illustrated in the drawings, which are only to facilitate and simplify the descriptions of this disclosure, and cannot used to instruct that the referred devices or components is in a specific location and is constructed and operated in a specific orientation, therefore, cannot be interpreted as limitations the disclosure. In addition, the terms of "first" and "second" can explicitly or implicitly mean one and more than one. In the descriptions of this disclosure, unless being otherwise stated, "multiple" means two or more than two.

In the descriptions of the present disclosure, it will be appreciated that, unless being otherwise rules and limits, the term "install", "dispose", "connected" should have a broad mean, for example, can means a fixed connection, or a detachable connection, or a integrated connection; and can means a mechanical connection or an electrical connection; also can means directly connection, or indirectly connection through an intermediate media, or an inner connection within two components. For one of ordinary skill in the art, it is possible to understand the specific meaning of the above terms in the present disclosure.

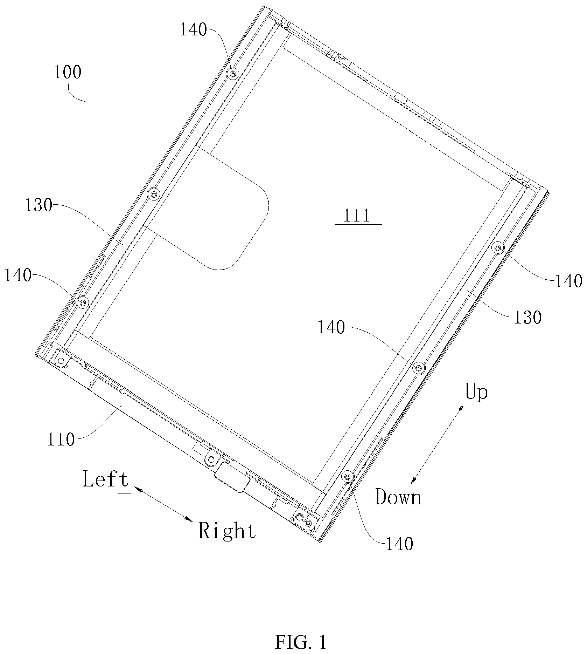

A shell assembly 100 of an electronic device 200 and the electronic device 200 are described in following with reference to FIG.1 to FIG.4.

As illustrated in FIG. 1 to FIG. 3, in the first embodiment of the disclosure, the shell assembly 100 of the electronic device 200 includes a shell component 101 and at least one reinforcing pillar 130. The shell component 101 includes a shell 120. The shell 120 includes a plate 121 and a side plate 122 extending substantially perpendicularly from edges of the plate 121. The plate 121 and the side plate 122 defines a receiving cavity (11) at least configuring for receiving a battery. The at least one reinforcing pillar 130 is received in the receiving cavity 11.

The at least one reinforcing pillar 130 can be fully embedded inside the shell component 101. Alternatively, the at least one reinforcing pillar 130 can be partially embedded inside the shell component 101 and partially exposed from the shell component 101.

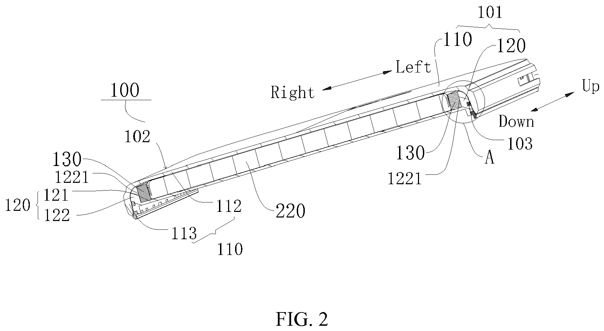

Specifically, as illustrated in FIG. 1 and FIG. 2, the shell component 101 further includes a cover 110. The cover 110 includes a base 112 and extending portion 113 substantially vertically extended form edges of the base 112. The extending portion 113 is positioned at a outer side of the side plate 122 away from the plate 121. The base 112 is opposite to and spaced from the plate 121. The cover 110 covers the receiving cavity 111. The at least one reinforcing pillar 130 is located between the base 112 of the cover 110 and the plate 121 of the shell 120. The receiving cavity 111 can receive a main circuit board of the electronic device 200, a battery 220 and so on. As illustrated in FIG, 3, when the battery 20 is received in the receiving cavity 11, the at least one reinforcing pillar 130 is positioned between the battery 220 and the side plate 122.

In at least one embodiment, the extending portion 113 can be detachably fixed on the side plate 122, for example, via bolts 103.

The at least one reinforcing pillar 130 can be physically integrally extending from or detachably positioned on at least one of the cover 110 and the shell 120. In other words, the at least one reinforcing pillar 130 can be physically integrally extending from or detachably positioned on the cover 110, or be physically integrally extending from or detachably positioned on the shell 120, or be physically integrally extending from or detachably positioned on both of the cover 110 and the shell 120.

It will be appreciated that, the term "shell assembly" may refer to one component or multiple components; the "receiving cavity" can be defined by one component or multiple components. That is, the shell component 101 of the shell assembly 100 can include only one of the cover 110 and the shell 120, or can include both the cover 110 and the shell 120, and/or other components. Accordingly, the receiving cavity 111 can be defined by the cover 110 or the shell 120, or can be defined by the cover 110 together the shell 120 and/or other components.

It will be appreciated that, a structural strength of the base 112 and the plate 121 of the shell component 101 corresponding to the receiving cavity 111 is low, and for the at least one reinforcing pillar 130 is positioned on at least one of the cover 110 and the shell 120, a structural strength of at least one of the cover 110 and the shell 120 can be increased, the structural strength of the shell assembly 100 can be further increased, thereby facilitating a light and thin design of the electronic device 200.

In the shell assembly 100 of electronic device 200 according to the embodiment of the present disclosure, for the at least one reinforcing pillar 130 is detachably positioned on at least one of the cover 110 and the shell 120, a structural strength of at least one of the cover 110 and the shell 120 can be increased, the structural strength of the shell assembly 100 can be further increased, then a bending resistance of the shell assembly 100 can be enhanced, thereby facilitating a light and thin design of the electronic device 200.

According to one embodiment of the disclosure, the at least one reinforcing pillar 130 is buckled to or adhered to the at least one of the cover 110 and the shell 120, which is facilitate to install the at least one reinforcing pillar 130 in the cover 110 or the shell 120. It will be appreciated that, when the at least one reinforcing pillar 130 is positioned on the cover 110, the at least one reinforcing pillar 130 can be buckled to or adhered to the cover 110, and when the at least one reinforcing pillar 130 is positioned on the shell 120, the at least one reinforcing pillar 130 can be buckled to or adhered to the shell 120.

It will be appreciated that, a connection between the at least one reinforcing pillar 130 and at least one of the cover 110 and the shell 120 is not limited to a buckle connection and an adhering connection, as long as the at least one reinforcing pillar 130 can be steadily positioned on at least one of the cover 110 and the shell 120. For example, the at least one reinforcing pillar 130 is fixed on the at least one of the cover 110 and the shell 120 via at least one threaded fastener 140. In at least one embodiment, as illustrated in FIG. 1 to FIG. 3, the at least one reinforcing pillar 130 is connected to the shell 120 via the at least one thread fastener 140.

Further, as illustrated in FIG. 1, there can be a plurality of thread fasteners 140, and the plurality of thread fasteners 140 is spaced form each other along a length direction of the at least one reinforcing pillar 130. Thus the at least one reinforcing pillar 130 can be steadily fixed on the at least one of the cover 110 and the shell 120 via the thread fasteners 140.

In order to facilitate the setting of the at least one reinforcing pillar 130, and to optimize a layout of the receiving cavity 111, according to one embodiment of the disclosure, the at least one reinforcing pillar 130 may extend along a length direction or a width direction of the receiving cavity 111. That is, the at least one reinforcing pillar 130 can extend along a length direction of the receiving cavity 111 (a vertical direction (up and down) as illustrated in FIG. 2), or the at least one reinforcing pillar 130 can extend along a width direction of the receiving cavity 111 (a horizontal direction (left and right) as illustrated in FIG. 2).

For example, as illustrated in FIG. 1 and FIG. 2, the at least one reinforcing pillar 130 may extend along a length direction of the receiving cavity 111 (a vertical direction as illustrated in FIG. 2). Therefore, a structural strength of the shell assembly 100 can be increased and a bending resistance of the shell assembly 100 can be enhanced. As an example of this disclosure, the at least one reinforcing pillar 130 can be defined by a plurality of reinforcing pillars 130, and the plurality of the reinforcing pillars 130 can be spaced from each other, thus to further enhance the bending resistance of the shell assembly 100.

For example, as the example illustrated in FIG. 1 and FIG. 2, there can be two reinforcing pillars 130, one reinforcing pillar 130 is adjacent to one end of the receiving cavity 111, and the other reinforcing pillar 130 is adjacent to the opposite end of the receiving cavity 111. In other words, both of the two reinforcing pillars 130 may extend along the length direction of the receiving cavity 111 (a vertical direction as illustrated in FIG. 1), with one reinforcing pillar 130 is located on the left side of the receiving cavity 111, and the other reinforcing pillar 130 is located on the right side of the receiving cavity 111.

In at least one embodiment, the two reinforcing pillars 130 are parallel with each other, one reinforcing pillar 130 is located on a left wall of the shell assembly 100, and the other reinforcing pillar 130 is located on a right wall of the shell assembly 100. In other words, as the example illustrated in FIG. 1 and FIG. 2, the side plate 122 comprises two wall portions 1221 opposite to each other, the two reinforcing pillars 130 are in contact with the two wall portions 1221 respectively.

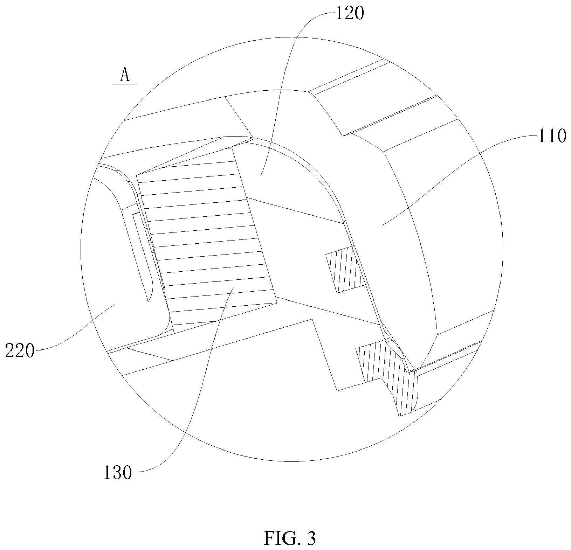

As an example of the present disclosure, as illustrated in FIG. 3, a cross-sectional shape of the at least one reinforcing pillar 130 is rectangular, thereby facilitating the setting of the at least one reinforcing pillar 130 on the cover 110 or the shell 120, and at the same time, it is also possible to increase the structural strength of the shell assembly 100 and enhance the bending resistance of the shell assembly 100. It will be appreciated that, the cross-sectional shape of the at least one reinforcing pillar 130 is not limited to rectangular, for example, the cross-sectional shape of the at least one reinforcing pillar 130 can be round, or can be other polygonal, such as triangle, square or hexagonal, to improve a connection strength and a connection stability between the at least one reinforcing pillar 130 and the cover 110 or the shell 120.

As an example of the disclosure, the at least one of the cover 110 and the shell 120 directly connected with the at least one reinforcing pillar 130 can be a injection molded part. It will be appreciated that, in case that the at least one reinforcing pillar 130 is directly connected to the cover 110, when the cover 110 is formed via an injection molding process, the at least one reinforcing pillar 130 can be received in a mold before the cover 110 is formed, then the cover 110 can be molded on the at least one reinforcing pillar 130 in the injection molding process. Similarly, in case that the at least one reinforcing pillar 130 is directly connected to the shell 120, when the shell 120 is formed via an injection molding process, the at least one reinforcing pillar 130 can be received in a mold before the shell 120 formed, then the shell 120 can be molded on the at least one reinforcing pillar 130 in the injection molding process. Therefore, a assembly process between the at least one reinforcing pillar 130 and the cover 110 or the shell 120 can be simplified, which can in turn shorten a production cycle and save production cost.

As an example of the disclosure, the at least one of the cover 110 and the shell 120 can be made of aluminum-magnesium alloy or aluminum alloy, to increase the structural strength of the shell assembly 100. To further increase the structural strength of the shell assembly 100, in an example of the disclosure, the at least one reinforcing pillar 130 could be made of stainless steel.

Here, it will be appreciated that, the cover 110, the shell 120, and the at least one reinforcing pillar 130 is not limited to be made of the above materials, as long as it can increase the structural strength of the shell assembly 100, for example, in another example of the present disclosure, a mechanical strength of the at least one reinforcing pillar 130 is greater than that of the at least one of the cover 110 and the shell 120 directly connected with the at least one reinforcing pillar 130. In other words, when the at least one reinforcing pillar 130 is positioned on the cover 110, the mechanical strength of the at least one reinforcing pillar 130 is greater than that of the cover 110; when the at least one reinforcing pillar 130 is positioned on the shell 120, the mechanical strength of the at least one reinforcing pillar 130 is greater than that of the shell 120.

As illustrated in FIG. 1 to FIG. 5, the electronic device 200 according to the second embodiment of the disclosure includes the shell assembly 100 as described above, a plurality of components received in the receiving cavity 111. The plurality of components can include at least one of a radio frequency (RF) circuit 230, a memory 240, an input unit 250, a wireless fidelity (Wi-Fi) module 260, at least one sensor 270, a audio circuit 280, a processor 290, a projection 300, a camera 310, a battery 220, etc.

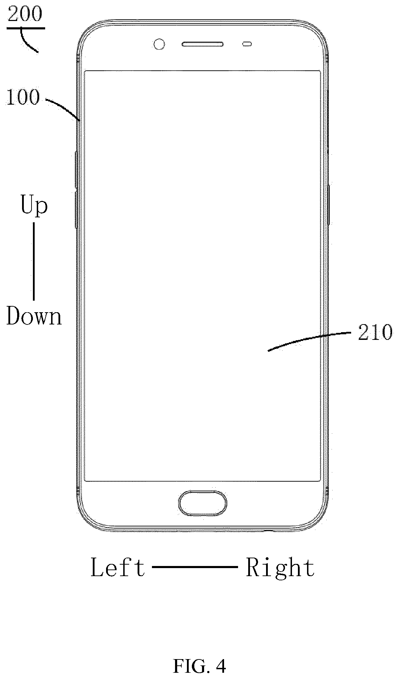

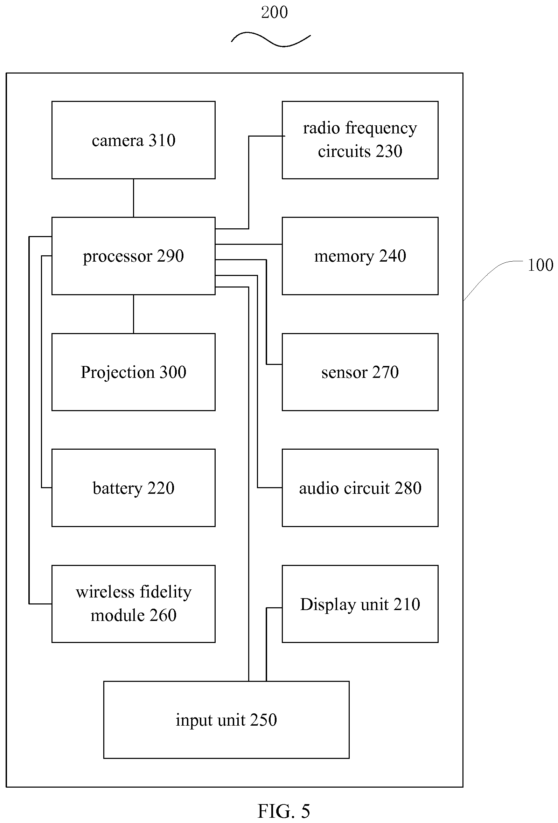

As illustrated in FIG. 4 and FIG. 5, the electronic device 200 according to the second embodiment of the disclosure may further includes a display unit 210. The display unit 210 can be at least partially imbedded in a front surface 102 of the shell 120. For example, the display unit 210 has a surface recessed in the front surface 102 and an opposite surface protruding from the front surface 102, or, the display unit 210 has a surface flush with the front surface 102 and has an opposite surface protruding from the front surface 102, or, the display unit 210 has a surface and an opposite surface all recessed in the front surface 102.

As the embodiment of the present disclosure, for the at least one reinforcing pillar 130 is physically integrally extending from or detachably positioned on at least one of the cover 110 and the shell 120, a structural strength of the at least one of the cover 110 and the shell 120 can be increased, a structural strength of the shell assembly 100 can be further increased, then a bending resistance of the shell assembly 100 can be enhanced, thereby facilitating a light and thin design of the electronic device 200.

According to the shell assembly 100 of the disclosure, as illustrated in FIG. 1 to FIG. 3, the shell component 101 of the electronic device 200 defines the receiving cavity 111 and includes at least one reinforcing pillar 130. The at least one reinforcing pillar 130 is physically integrally extending from or detachably connected to at least one of the cover 110 and the shell 120 of the shell component 101 and is close to the receiving cavity 111. The at least one reinforcing pillar 130 can be fully embedded inside the shell component 101, or the at least one reinforcing pillar 130 can be partially embedded inside the shell component 101, and partially exposed from the shell component 101. It will be appreciated that, the term "shell assembly" may refer to one component or multiple components; the "receiving cavity" can be defined by one component or multiple components. That is, the shell component 101 of the shell assembly 100 can include only one of the cover 110 and the shell 120, or can include both the cover 110 and the shell 120, and/or other components. Accordingly, the receiving cavity 111 can be defined by the cover 110 or the shell 120, or can be defined by the cover 110 together the shell 120 and/or other components.

In addition, a structural strength of the base 112 and the plate 121 of the shell component 101 corresponding to the receiving cavity 111 is low, and for the at least one reinforcing pillar 130 is positioned on the shell component 101, the structural strength of the shell assembly 100 can be increased, thereby facilitating the light and thin design of the electronic device 200.

In the embodiment of the present disclosure, for the at least one reinforcing pillar 130 is physically integrally extending from or detachably positioned on at least one of the cover 110 and the shell 120, a structural strength of the shell assembly 100 can be increased, then a bending resistance of the shell assembly 100 can be enhanced, thereby facilitating the light and thin design of the electronic device 200.

The electronic device 200 in embodiments of the disclosure will be described in detail with reference to FIG. 1 to FIG. 5. It will be appreciated that, the term "electronic device" used herein can refer to "communication terminal" or "terminal equipment", which can include but is not limited to a device connected through a wired line and/or receive/transmit communication signal via a wireless interface. The wired line can be a public switched telephone network (PSTN), a digital subscriber line (DSL), a digital cable, a direct cable connection, and/or another data connection/network. The wireless interface can be a cellular network, a wireless local area network (WLAN), a digital television network, satellite network, a AM and FM radio transmitter, and/or other communication terminals of a digital video broadcasting handheld (DVB-H) network. Communication terminals configured to communicate through wireless interfaces can be called "wireless communication terminal", "wireless terminal" and/or "mobile terminal". Examples of "mobile terminal" can include but is not limited to: a satellite or a cellular phone; a personal communication system (PCS) terminal that can combine cellular radio and data processing, facsimile and data communication capabilities; a radio phone, a pager, or a personal digital assistant (PDA) with Internet/Intranet access, Web browser, notepad, calendar and/or global positioning system (GPS) receiver; a conventional laptop and/or handheld type receiver, and/or other electronic devices including radio telephone transceivers.

The electronic device 200 can be a device which is able to receive and process data from outside, or, the electronic device can be a device including a built-in battery 220 and being able to charge the battery 220 with outside current. For example, the electronic device can be a mobile phone, a tablet, a computing device or an information display device, etc.

The mobile phone is introduced as an example of the electronic device 200 in the present disclosure. It will be appreciated that the following description is only a sample statement rather than a specific limitation of the disclosure.

In one embodiment of the present disclosure, as illustrated in FIG. 5, the mobile phone includes: the shell assembly 100, a display unit 210, a radio frequency (RF) circuit 230, a memory 240, an input unit 250, a wireless fidelity (Wi-Fi) module 260, at least one sensor 270, a audio circuit 280, a processor 290, a projection 300, a camera 310, a battery 220, etc.

As illustrated in FIG. 1 to FIG. 3, the shell assembly 100 includes a shell component 101 and at least one reinforcing pillar130. The shell component 101 defines a receiving cavity 111, the at least one reinforcing pillar 130 is received in the receiving cavity 111 and is physically integrally extending from or detachably positioned on the shell component 101. The shell component 101 includes a cover 110 and a shell 120. The cover 110 and the shell 120 cooperatively define the receiving cavity 111. The cover 110 can be used as a back cover (or battery cover) of the mobile phone, and the shell 120 can be used as a front cover of the mobile phone. As illustrated in FIG. 5, the RF circuit 230, the memory 240, the input unit 250, the Wi-Fi module 260, the at least one sensor 270, the audio circuit 280, the processor 290, the projection 300, the camera 310, the battery 220, and other components can be received in the receiving cavity 111. As illustrated in FIG. 4, the display unit 210 can be mounted on a front surface 102 of the shell assembly 100, and the display unit 210 is at least partially imbedded in the shell assembly 100. For example, the display unit 210 has a surface recessed in the front surface 102 and an opposite surface protruding from the front surface 102, or, the display unit 210 has a surface flush with the front surface 102 and has an opposite surface protruding from the front surface 102, or, the display unit 210 has a surface and an opposite surface all recessed in the front surface 102.

As illustrated in FIG. 2 to FIG. 3, the at least one reinforcing pillar 130 is connected to the shell 120 via the thread fastener 140. The at least one reinforcing pillar 130 extends along the length direction of the cavity 111 (as illustrated in FIG. 2). As illustrated in FIG. 1, there are two reinforcing pillars 130 extending along the length direction of the receiving cavity 111, one reinforcing pillar 130 is located on the left side of the receiving cavity 111, and the other reinforcing pillar 130 is located on the right side of the receiving cavity 111. One reinforcing pillar 130 is located on a left wall of the shell assembly 100, and the other reinforcing pillar 130 is located on a right wall of the shell assembly 100; in other words, one reinforcing pillar 130 is in contact with the side plate 122 on one side of the shell assembly 100, and the other reinforcing pillar 130 is in contact with the side plate 122 on the opposite side of the shell assembly 100. Therefore, a structural strength of the shell assembly 100 can be increased and a bending resistance of the shell assembly 100 can be enhanced.

As illustrated in FIG. 3, a cross-sectional shape of the at least one reinforcing pillar 130 is rectangular, which can be facilitate the setting of the at least one reinforcing pillar 130 on the cover 110 or the shell 120, and can increase the structural strength of the shell assembly 100, and also can enhance the bending resistance of the shell assembly 100. Further, a mechanical strength of the at least one reinforcing pillar 130 is greater than that of the at least one of the cover 110 and the shell 120.

The RF circuit 230 can be used to receive and send signals during a process of sending and receiving messages or calls, especially when a downstream information of the base station is received and processed by the processor 290, and the data on the mobile phone are sent to the base station. Generally, the RF circuit 230 include but not limited to antennas, at least one amplifier, transceivers, couplers, low-noise amplifiers, duplexers, etc. In addition, the RF circuit 230 can communicate with the network and other devices through wireless communication. The above wireless communication may use any communication standard or protocol, which includes but not limited to global system of mobile communication (GSM), general packet radio service (GPRS), code division multiple access (CDMA), wideband code division multiple access (WCDMA), long term evolution (LTE), E-mail, short messaging service (SMS) and so on.

The memory 240 may be configured to store software programs and modules, and the processor 290 executes various function applications and data processing of the mobile phone by running the software programs and the modules stored in the memory. The memory 240 may mainly include a program storage region and a data storage region, the storage program region may store an operation system, application programs needed for at least one function (a fingerprint scanning function, a fingerprint matching function, and an unlocking function) and so on; and the data storage region may store data (such as audio data, a phone book, etc.) created according to use of the mobile phone, and so on. In addition, the memory may include a high-speed RAM, and may further include a nonvolatile memory such as one of at least a disk storage device, a flash device, or other nonvolatile solid storage devices.

The input unit 250 may be configured to receive input digital or character information and to generate key signal input associated with user setting and functional control of the mobile phone. Specifically, the input unit may includes a touch panel, and other input devices. The touch panel, also referred to as a touch screen, may receive a touch operation of the user thereon or nearby (e.g., operation on or near the touch panel by a user using a finger or stylus, or any suitable object or attachment), and drive a corresponding connection device according to a preset program. The touch panel may include a touch detection device and a touch controller. The touch detection device detects the touching position of the user and detects a signal resulted from the touch operation, and transmits the signal to the touch controller. The touch controller receives the touch information from the touch detection device and converts the information into contact coordinates and sends it to the processor, the touch controller can receive and execute the command sent by the processor. In addition, the touch panel can be realized using various types such as resistive, capacitive, infrared, and surface acoustic waves. In addition to the touch panel, the input unit may still include other input elements. The other input elements may include, but is not limited to, at least one of a physical keyboard, a function key (such as volume control buttons, switch buttons and so on), a trackball, a mouse, and a joystick.

The display unit 210 can be used to display information entered by the user or the information provided to the user and the various menus of the phone. The display unit 210 can include display panel, and optionally, a liquid crystal display (LCD), an organic light-emitting diode (OLED) and other forms can be used to dispose the display panel. Further, the touch panel can cover the display pane; when detecting a touch whereon or nearby, the touch panel transmits a detecting result to the processor to determine a type of touch events, then the processor provides a corresponding visual output according to the type of touch events on the display panel.

A visible area of the visual output on the display panel can be used as the later "display area". The touch panel and the display panel can be used as two separate components to implement the input and output functions of the mobile phone, or, the touch panel can be integrated with the display panel to implement the input and output functions of the mobile phone.

The at least one sensor 270 can be an attitude sensor, a light sensor, and other sensors.

Specifically, the attitude sensor can also be called a motion sensor; and, a gravity sensor can be one kind of the motion sensor. The gravity sensor uses a cantilevered displacer, and drives electric contact by an elastic energy storage spring made of sensitive element, to transform gravity changes into electrical signals.

A accelerometer sensor can be another kind of motion sensor. The accelerometer sensor can detect the magnitude of acceleration in all directions (typically three axes, that is, *x*, *y*, and *z*); when stationary, the accelerometer sensor can detect the magnitude and direction of gravity when stationary; the accelerometer sensor can also identify the application of mobile gestures (such as vertical and horizontal screen switch, related games, magnetometer attitude calibration), or the accelerometer sensor can be used for vibration recognition of related functions (such as a pedometer, percussion) and so on.

In the phone, the above listed motion sensor can be used as an element to obtain the following "gesture parameters", but is not limited to this; other sensors which can obtain "attitude parameters" will all fall into a scope protection of this disclosure, for example, gyroscope, etc., and a working principle and data processing of the gyroscope can be similar to the existing technology, here, in order to avoid redundancy, omit the details.

The light sensor may include an ambient light sensor and a proximity sensor, among which the ambient light sensor may adjust the brightness of the display panel according to ambient lights, and the proximity sensor may turn off the display panel and/or backlight when the mobile phone reaches nearby the ear.

The mobile phone can also include a gyroscope, barometer, hygrometer, thermometer, infrared sensor and other sensors, and will not repeat here.

The audio circuit 280, a speaker, and a microphone may provide an audio interface between the user and the mobile phone. The audio circuit 280 may convert received audio data into electrical data and transfer the electrical data to the speaker; thereafter the speaker converts the electrical data into a sound signal for output. On the other hand, the microphone converts the received sound signal into an electrical signal which will be received by the audio circuit 280 and converted into audio data to output to the processor, the audio data is processed by the processor 290 and transmitted via the RF circuit 230, for example, another mobile phone, or, the audio data is output to the memory 240 for further processing.

Wi-Fi belongs to a short-range wireless transmission technology, the mobile phone may assist the user in E-mail receiving and sending, webpage browsing, access to streaming media and the like by means of the Wi-Fi module; Wi-Fi provides users with wireless broadband Internet access.

The processor 290 is a control center of the mobile phone, it uses various interfaces and lines to connect various parts of the whole mobile phone, runs or executes software programs and/or modules stored in the memory 240, and calls data stored in the memory 240 to perform various functions of the mobile phone and process data, thereby monitoring the mobile phone. In at least one implementation, the processor may include one or more processing units; for example, the processor 290 may integrate an application processor and a modem processor, wherein the application processor handles the operating system, the user interface, the application, and so on, and the modem processor mainly processes wireless communication.

It will be appreciated that the above-mentioned modem processor may not be integrated into the processor 290.

Also, the processor 290, as an implementation component of the above processing units, can execute a same or similar functionality as the processing units.

The phone also includes a power supply (such as the battery 220) that supplies power to various components.

In at least one embodiment, the power supply may be logically connected to the processor via a power management system to enable management of charging, discharging, and power consumption through the power management system. Although not illustrated, the mobile phone may include a Bluetooth module, etc., and will not be elaborated here.

It will be appreciated that the mobile phone is only a kind of electronic device 200, for example, the present disclosure is not particularly limited to be applied to mobile phones, tablet computers and other electronic equipment.

In this description, the terms "an example", "one embodiment", "embodiments" or "examples" refers to that specific characteristics, structure, material, or features combined with the examples is contained in at least one example of this disclosure. In this description, the indicative representation of the above terms does not necessarily refer to a same embodiments or examples. Moreover, the specific features, structures, materials, or characteristics of the description can be combined in any one or more embodiments or examples.

While the present disclosure has been described in detail above with reference to the exemplary embodiments, the scope of the present disclosure is not limited thereto. As will occur to those skilled in the art, the present disclosure is susceptible to various modifications and changes. Therefore, the scope of the present disclosure should be determined by the scope of the claims.

## Claims

1. A shell assembly (100) of an electronic device (200), comprising:
a shell (120), comprising a plate (121) and a side plate (122) extending from the plate (121), the plate (121) and the side plate (122) cooperatively defining a receiving cavity (11) at least configured for receiving a battery (220);
**characterised in that** the shell assembly further comprises:
at least one reinforcing pillar (130), received in the receiving cavity (11) and arranged adjacent to the side plate (122), when the battery (220) being received in the receiving cavity (11), the at least one reinforcing pillar (130) being positioned between the battery (220) and the side plate (122).

2. The shell assembly (100) of claim 1, further comprising a cover (110) detachably coupled to the shell (120); wherein the cover (110) covers the receiving cavity (11), the at least one reinforcing pillar (130) is located between the cover (110) and the shell (120).

3. The shell assembly (100) of claim 2, wherein the cover (110) comprises a base (112) and an extending portion (113) extending from the base (112), the extending portion (113) is detachably positioned at an outer side of the side plate (122), the base (112)is opposite to and spaced from the plate (121), and the at least one reinforcing pillar (130) is located between the base (112) of the cover (110) and the plate (121) of the shell (120).

4. The shell assembly (100) of claim 3, wherein the at least one reinforcing pillar (130) is physically integrally extending from or detachably retained to at least one of the base (112) of the cover (110) and the plate (121) of the shell (120).

5. The shell assembly (100) of claim 4, wherein the at least one reinforcing pillar (130) is buckled to, adhered to, or bolted to at least one of the base (112) of the cover (110) and the plate (121) of the shell (120).

6. The shell assembly (100) of any one of claims 1 to 5, wherein the at least one reinforcing pillar (130) is defined by two reinforcing pillars (130), the side plate (122) comprises two wall portions (122)1 opposite to each other, the two reinforcing pillars (130) are in contact with the two wall portions (122)1 respectively, and the two reinforcing pillars (130) are parallel to each other.

7. The shell assembly (100) of any one of claims 1 to 6, wherein the shell (120) is an injection molded part, and the shell (120) is molded on the at least one reinforcing pillar (130) via an injection molding process.

8. The shell assembly (100) of any one of claims 1 to 7, wherein a mechanical strength of the at least one reinforcing pillar (130) is greater than that of the shell (120).

9. The shell assembly (100) of claim 8, wherein the shell (120) is made of aluminium-magnesium alloy or aluminium alloy, and the at least one reinforcing pillar (130) is made of stainless steel.

10. The shell assembly (100) of any one of claims 1 to 9, wherein the at least one reinforcing pillar (130) is extended along a length direction or a width direction of the receiving cavity 11; the at least one reinforcing pillar (130) is defined by a plurality of reinforcing pillars (130), and the plurality of reinforcing pillars (130) is spaced from each other.

11. The shell assembly (100) of any one of claims 1 to 10, wherein the at least one reinforcing pillar (130) is fully embedded in the receiving cavity (11); or the at least one reinforcing pillar (130) is partially embedded in the receiving cavity (11), and partially exposed from the receiving cavity (11).

12. An electronic device (200), comprising:
a shell assembly (100) of any one of claims 1 to 11; and
a battery (220), received in the receiving cavity (11).

13. The electronic device (200) of claim 11, further comprising a plurality of components received in the receiving cavity (11); the plurality of components comprising at least one of a radio frequency circuit (230), a memory (240), an input unit (250), a wireless fidelity module (260), at least one sensor (270), a audio circuit (280), a processor (290), and a camera (310).

14. An electronic device (200), comprising:
a shell assembly (100) of any one of claims 1 to 11;
a display unit (210), mounted on a front surface (102) of the shell (120), and being at least partially imbedded in the shell (120); and
a battery (220), received in the receiving cavity (11);
wherein the at least one reinforcing pillar (130) is arranged adjacent to the side plate (122) and is positioned between the battery (220) and the side plate (122), and wherein the electronic device is a mobile phone.

15. The mobile phone (200) of claim 14, further comprising a plurality of components received in the receiving cavity (11); the plurality of components comprising at least one of a radio frequency circuit (230), a memory (240), an input unit (250), a wireless fidelity module (260), at least one sensor (270), a audio circuit (280), a processor (290), and a camera (310).

## Patentansprüche

1. Gehäuseschalenanordnung (100) einer elektronischen Vorrichtung (200), wobei diese Folgendes umfasst:
eine Gehäuseschale (120), die eine Platte (121) und eine Seitenplatte (122) umfasst, die sich von der Platte (121) weg erstreckt, wobei die Platte (121) und die Seitenplatte (122) zusammen einen Aufnahmehohlraum (11) definieren, der zumindest ausgebildet ist, um eine Batterie (220) aufzunehmen;
**dadurch gekennzeichnet, dass** die Gehäuseschalenanordnung ferner Folgendes umfasst:
zumindest einen Verstärkungsholm (130), der in dem Aufnahmehohlraum (11) aufgenommen ist und benachbart in Bezug auf die Seitenplatte (122) angeordnet ist, wobei, wenn die Batterie (220) in dem Aufnahmehohlraum (11) aufgenommen ist, der zumindest eine Verstärkungsholm (130) zwischen der Batterie (220) und der Seitenplatte (122) angeordnet ist.

2. Gehäuseschalenanordnung (100) nach Anspruch 1, die ferner eine Abdeckung (110) umfasst, die abnehmbar mit der Gehäuseschale (120) verbunden ist; wobei, wenn die Abdeckung (110) den Aufnahmehohlraum (11) abdeckt, der zumindest eine Verstärkungsholm (130) zwischen der Abdeckung (110) und dem Gehäuse (120) angeordnet ist.

3. Gehäuseschalenanordnung (100) nach Anspruch 2, wobei die Abdeckung (110) eine Basis (112) und einen Erstreckungsabschnitt (113) umfasst, der sich von der Basis (112) weg erstreckt, wobei der Erstreckungsabschnitt (113) abnehmbar an einer Außenseite der Seitenplatte (122) angeordnet ist, wobei die Basis (112) der Platte (121) gegenüberliegend und von dieser beabstandet angeordnet ist und wobei der zumindest eine Verstärkungsholm (130) zwischen der Basis (112) der Abdeckung (110) und der Platte (121) der Gehäuseschale (120) angeordnet ist.

4. Gehäuseschalenanordnung (100) nach Anspruch 3, wobei der zumindest ein Verstärkungsholm (130) sich physisch einstückig von zumindest einem aus der Basis (112) der Abdeckung (110) und der Platte (121) der Gehäuseschale (120) weg erstreckt oder abnehmbar an zumindest einem aus der Basis (112) der Abdeckung (110) und der Platte (121) der Gehäuseschale (120) befestigt ist.

5. Gehäuseschalenanordnung (100) nach Anspruch 4, wobei der zumindest eine Verstärkungsholm (130) an zumindest einem aus der Basis (112) der Abdeckung (110) und der Platte (121) der Gehäuseschale (120) angeschnallt, anhaftet oder angeschraubt ist.

6. Gehäuseschalenanordnung (100) nach einem der Ansprüche 1 bis 5, wobei der zumindest eine Verstärkungsholm (130) durch zwei Verstärkungsholme (130) definiert ist, die Seitenplatte (122) zwei Wandabschnitte (122)1 umfasst, die einander gegenüberliegen, wobei die zwei Verstärkungsholme (130) jeweils mit den zwei Wandabschnitten (122)1 in Kontakt stehen und die zwei Verstärkungsholme (130) parallel zueinander angeordnet sind.

7. Gehäuseschalenanordnung (100) nach einem der Ansprüche 1 bis 6, wobei die Gehäuseschale (120) ein spritzgegossenes Teil ist und die Gehäuseschale (120) auf den zumindest einen Verstärkungsholm (130) durch ein Spritzgussverfahren aufgeformt ist.

8. Gehäuseschalenanordnung (100) nach einem der Ansprüche 1 bis 7, wobei eine mechanische Festigkeit des zumindest einen Verstärkungsholms (130) größer ist als jene der Gehäuseschale (120).

9. Gehäuseschalenanordnung (100) nach Anspruch 8, wobei die Gehäuseschale (120) aus einer Aluminium-Magnesium-Legierung oder einer Aluminiumlegierung besteht und der zumindest eine Verstärkungsholm (130) aus Edelstahl besteht.

10. Gehäuseschalenanordnung (100) nach einem der Ansprüche 1 bis 9, wobei der zumindest eine Verstärkungsholm (130) sich entlang einer Längsrichtung oder eine Breiterichtung des Aufnahmehohlraums (11) erstreckt; der zumindest eine Verstärkungsholm (130) durch eine Vielzahl von Verstärkungsholmen (130) definiert ist und die Vielzahl von Verstärkungsholmen (130) voneinander beabstandet sind.

11. Gehäuseschalenanordnung (100) nach einem der Ansprüche 1 bis 10, wobei der zumindest eine Verstärkungsholm (130) vollständig in dem Aufnahmehohlraum (11) eingebettet ist oder der zumindest eine Verstärkungsholm (130) teilweise in dem Aufnahmehohlraum (11) eingebettet ist und teilweise in Bezug auf den Aufnahmehohlraum (11) freiliegt.

12. Elektronische Vorrichtung (200), die Folgendes umfasst:
eine Gehäuseschalenanordnung (100) nach einem der Ansprüche 1 bis 11 und
eine Batterie (220), die in dem Aufnahmehohlraum (11) aufgenommen ist.

13. Elektronische Vorrichtung (200) nach Anspruch 11, die ferner eine Vielzahl von Bauteilen umfasst, die in dem Aufnahmehohlraum (11) aufgenommen ist; wobei die Vielzahl von Bauteilen zumindest eines aus einer Hochfrequenzschaltung (230), einem Speicher (240), einer Eingabeeinheit (250), einem kabellosen Netzwerkverbindungsmodul (260), zumindest einem Sensor (270), einer Audioschaltung (280), einem Prozessor (290) und einer Kamera (310) umfasst.

14. Elektronische Vorrichtung (200), die Folgendes umfasst:
eine Gehäuseschalenanordnung (100) nach einem der Ansprüche 1 bis 11;
eine Anzeigeeinheit (210), die auf einer Vorderfläche (102) der Gehäuseschale (120) angebracht ist und zumindest teilweise in die Gehäuseschale (120) eingebettet ist; und
eine Batterie (220), die in dem Aufnahmehohlraum (11) aufgenommen ist;
wobei der zumindest eine Verstärkungsholm (130) benachbart in Bezug auf die Seitenplatte (122) angeordnet ist und zwischen der Batterie (220) und der Seitenplatte (122) angeordnet ist und wobei die elektronische Vorrichtung ein Mobiltelefon ist.

15. Mobiltelefon (200) nach Anspruch 14, das ferner eine Vielzahl von Bauteilen umfasst, die in dem Aufnahmehohlraum (11) aufgenommen ist; wobei die Vielzahl von Bauteilen zumindest eines aus einer Hochfrequenzschaltung (230), einem Speicher (240), einer Eingabeeinheit (250), einem kabellosen Netzwerkverbindungsmodul (260), zumindest einem Sensor (270), einer Audioschaltung (280), einem Prozessor (290) und einer Kamera (310) umfasst.

## Revendications

1. Ensemble de coque (100) d'un dispositif électronique (200), comprenant :
une coque (120), comprenant une plaque (121) et une plaque latérale (122) s'étendant depuis la plaque (121), la plaque (121) et plaque latérale (122) définissant en coopération une cavité de réception (11) configurée au moins pour recevoir une batterie (220) ;
**caractérisé en ce que** l'ensemble de coque comprend en outre :
au moins un pilier de renforcement (130), reçu dans la cavité de réception (11) et agencé de manière adjacente à la plaque latérale (122), lorsque la batterie (220) est reçue dans la cavité de réception (11), le au moins un pilier de renforcement (130) étant positionné entre la batterie (220) et la plaque latérale (122).

2. Ensemble de coque (100) selon la revendication 1, comprenant en outre un couvercle (110) couplé de manière amovible à la coque (120) ; dans lequel le couvercle (110) recouvre la cavité de réception (11), le au moins un pilier de renforcement (130) est situé entre le couvercle (110) et la coque (120).

3. Ensemble de coque (100) selon la revendication 2, dans lequel le couvercle (110) comprend une base (112) et une partie d'extension (113) s'étendant depuis la base (112), la partie d'extension (113) est positionnée de manière amovible sur un côté extérieur de la plaque latérale (122), la base (112) est opposée à la plaque (121) et espacée de celle-ci, et le au moins un pilier de renforcement (130) est situé entre la base (112) du couvercle (110) et la plaque (121) de la coque (120).

4. Ensemble de coque (100) selon la revendication 3, dans lequel le au moins un pilier de renforcement (130) s'étend physiquement d'un seul tenant ou est retenu de manière amovible sur au moins l'une de la base (112) du couvercle (110) et de la plaque (121) de la coque (120).

5. Ensemble de coque (100) selon la revendication 4, dans lequel le au moins un pilier de renforcement (130) est attaché, collé ou boulonné à au moins l'une de la base (112) du couvercle (110) et de la plaque (121) de la coque (120).

6. Ensemble de coque (100) selon l'une quelconque des revendications 1 à 5, dans lequel le au moins un pilier de renforcement (130) est défini par deux piliers de renforcement (130), la plaque latérale (122) comprend deux parties de paroi (122)1 opposées l'une à l'autre, les deux piliers de renforcement (130) sont en contact avec les deux parties de paroi (122 1 respectivement, et les deux piliers de renforcement (130) sont parallèles l'un à l'autre.

7. Ensemble de coque (100) selon l'une quelconque des revendications 1 à 6, dans lequel la coque (120) est une pièce moulée par injection, et la coque (120) est moulée sur le au moins un pilier de renforcement (130) via un processus de moulage par injection.

8. Ensemble de coque (100) selon l'une quelconque des revendications 1 à 7, dans lequel une résistance mécanique du au moins un pilier de renforcement (130) est supérieure à celle de la coque (120).

9. Ensemble de coque (100) selon la revendication 8, dans lequel la coque (120) est en alliage d'aluminium-magnésium ou en alliage d'aluminium, et le au moins un pilier de renforcement (130) est en acier inoxydable.

10. Ensemble de coque (100) selon l'une quelconque des revendications 1 à 9, dans lequel le au moins un pilier de renforcement (130) est étendu dans une direction de longueur ou une direction de largeur de la cavité de réception 11 ; le au moins un pilier de renforcement (130) est défini par une pluralité de piliers de renforcement (130), et la pluralité de piliers de renforcement (130) sont espacés les uns des autres.

11. Ensemble de coque (100) selon l'une quelconque des revendications 1 à 10, dans lequel le au moins un pilier de renforcement (130) est complètement intégré dans la cavité de réception (11) ; ou le au moins un pilier de renforcement (130) est partiellement intégré dans la cavité de réception (11) et partiellement exposé à partir de la cavité de réception (11).

12. Dispositif électronique (200) comprenant :
un ensemble de coque (100) selon l'une quelconque des revendications 1 à 11 ; et
une batterie (220) reçue dans la cavité réceptrice (11).

13. Dispositif électronique (200) selon la revendication 11, comprenant en outre une pluralité de composants reçus dans la cavité de réception (11) ; la pluralité de composants comprenant au moins un parmi un circuit radiofréquence (230), une mémoire (240), une unité d'entrée (250), un module de fidélité sans fil (260), au moins un capteur (270), un circuit audio (280), un processeur (290) et une caméra (310).

14. Dispositif électronique (200) comprenant :
un ensemble de coque (100) selon l'une quelconque des revendications 1 à 11 ;
une unité d'affichage (210), montée sur une surface avant (102) de la coque (120), et étant au moins partiellement intégrée dans la coque (120) ; et
une batterie (220) reçue dans la cavité de réception (11) ;
dans lequel le au moins un pilier de renforcement (130) est agencé de manière adjacente à la plaque latérale (122) et est positionné entre la batterie (220) et la plaque latérale (122), et dans lequel le dispositif électronique est un téléphone portable.

15. Téléphone mobile (200) selon la revendication 14, comprenant en outre une pluralité de composants reçus dans la cavité de réception (11) ; la pluralité de composants comprenant au moins un parmi un circuit radiofréquence (230), une mémoire (240), une unité d'entrée (250), un module de fidélité sans fil (260), au moins un capteur (270), un circuit audio (280), un processeur (290) et une caméra (310).
